(19) Europäisches Patentamt / European Patent Office / Office européen des brevets

(11) **EP 2 039 803 B1**

## (12) EUROPEAN PATENT SPECIFICATION

(45) Date of publication and mention
of the grant of the patent:
**18.08.2010 Bulletin 2010/33**

(51) Int Cl.:
*C23C 30/00* (2006.01)   *B22F 7/00* (2006.01)
*B22F 7/06* (2006.01)

(21) Application number: **08162495.9**

(22) Date of filing: **18.08.2008**

(54) **Coated cutting tool for turning of heat resistant super alloys (HRSA)**

Beschichtetes Schneidwerkzeug für Dreharbeiten an hitzbeständigen Superlegierungen

Outil de coupe revêtu pour le tournage de superalliages résistant à la chaleur

(84) Designated Contracting States:
**AT BE BG CH CY CZ DE DK EE ES FI FR GB GR
HR HU IE IS IT LI LT LU LV MC MT NL NO PL PT
RO SE SI SK TR**

(30) Priority: **24.08.2007  SE 0701910**

(43) Date of publication of application:
**25.03.2009  Bulletin 2009/13**

(73) Proprietor: **SECO TOOLS AB (publ)
737 82 Fagersta (SE)**

(72) Inventors:
• **Sundström, Erik
73746, Fagersta (SE)**
• **M'Saoubi, Rachid
SE-737 40, Fagersta (SE)**
• **Andersson, Jon
SE-723 51, Västerås (SE)**

(74) Representative: **Hägglöf, Henrik
Sandvik Intellectual Property AB
811 81 Sandviken (SE)**

(56) References cited:
**EP-A- 1 795 628     EP-A- 1 798 308
EP-A- 1 953 269**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

The present invention relates to a cutting tool insert consisting of a cemented carbide substrate and a coating, particularly useful for general turning of heat resistant super alloys. Fine grained substrate in combination with a thick PVD-coating with a reduced residual strain level greatly improves the wear resistance.

Superalloys are a broad range of nickel, iron and cobalt base alloys developed specifically for applications demanding exceptional mechanical and chemical properties at elevated temperatures. The classic use for these alloys is in the hot end of aircraft engines and land based turbines. Almost every metallurgical change made to improve the high temperature properties makes it more difficult to machine these alloys.

As high temperature strength is increased, the alloys become harder and stiffer at the cutting temperature. It results in increased cutting forces and increased wear on the cutting edge during machining.

Because stronger materials generate more heat during chip formation and because the thermal heat conductivity of these alloys is relatively low, very high cutting temperatures are generated, which also contributes to an increased wear of the cutting edge.

To make matters even worse, as the alloys are heat treated to modify the as cast or solution treated properties, abrasive carbide precipitates or other second phase particles often form. These particles also cause rapid wear of the cutting edge.

An example of cutting tool inserts presently used in the machining of superalloys is given in the European patent application EP 1 798 308 A2.

It is an object of the present invention to provide a coated cemented carbide, for general wet machining of superalloys, with improved wear resistance.

It has now surprisingly been found that a cemented carbide with low Co-content and sub micron WC-grain size coated with a single (Ti,Al)N-layer grown using physical vapor deposition greatly improves the productivity in general machining of superalloys under wet conditions.

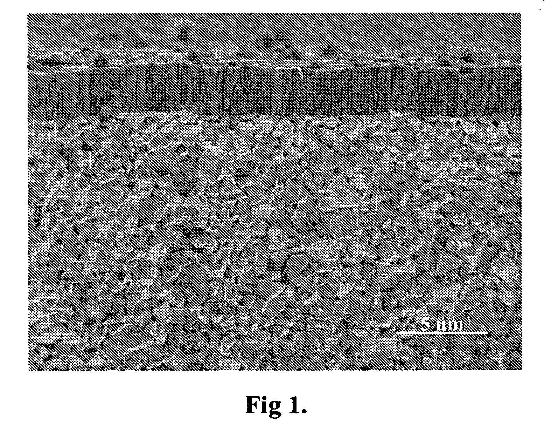

Fig 1 shows a fracture surface of a coated cemented carbide substrate according to the present invention in which:

1. Cemented carbide body and
2. Single layer of (Ti,Al)N.

According to the present invention there is now provided a coated cutting tool insert consisting of a substrate and a coating. The substrate consists of WC, 5.0-7.0, preferably 5.5-6.5, most preferably 5.8-6.2, wt-% Co, 0.22-0.43, preferably 0.24-0.33, most preferably 0.26-0.29 wt-% Cr with a coercivity (Hc) of 19-28, preferably 21-27, preferably 22.5-26.5 kA/m. Preferably, the edge radius of the inserts before coating is between 15 and 30 $\mu$m.

The coating consists of a single layer of $(Ti_xAl_{1-x})N$, where x is between 0.25 and 0.50, preferably between 0.30 and 0.40, most preferably between 0.33 and 0.35. The crystal structure of the (Ti,Al)N-layer is of NaCl type. The total thickness of the layer is between 3.0 and 5.0 $\mu$m, preferably between 3.5 and 4.5 $\mu$m. The thickness is measured on the middle of the flank face.

The layer is strongly textured in the (200)-direction, with a texture coefficient TC(200) of between 1.6 and 2.1.

The texture coefficient (TC) is defined as follows:

$$TC(hkl) \;=\; \frac{I(hkl)}{I_0(hkl)}\left[\frac{1}{n}\sum_{n=1}^{n}\frac{I(hkl)}{I_0(hkl)}\right]^{-1}$$

where

I(hkl) = intensity of the (hkl) reflection
$I_O$(hkl) = standard intensity according to JCPDS card no 38-1420
n = number of reflections used in the calculation
(hkl) reflections used are: (111), (200), (220).

The layer is in compressive residual stress with a strain of $2.5*10^{-3}$-$5.0*10^{-3}$, preferably $3.0*10^{-3}$-$4.0*10^{-3}$.

On top of the (Ti,Al)N a TiN-layer of between 0.1 and 0.5 $\mu$m thickness may be deposited.

The present invention also relates to a method of making a coated cutting tool insert consisting of a substrate and a coating. The substrate is made by conventional powder metallurgical methods milling, pressing and sintering. It has a composition of WC, 5.0-7.0, preferably 5.5-6.5, most preferably 5.8-6.2, wt-% Co, 0.22-0.43, preferably 0.24-0.33, most preferably 0.26-0.29, wt-% Cr with a coercivity (Hc) of 19-28, preferably 21-27, most preferably 22.5-26.5 kA/m.

Before coating the inserts are edge-honed by wet-blasting to an edge radius of preferably between 15 and 30 $\mu$m.

The method used to grow the layer is based on arc evaporation of an alloyed, or composite cathode, under the following conditions: The Ti+Al cathode composition is 25 to 50 at-% Ti, preferably 30 to 40 at-% Ti, most preferably 33 to 35 at-% Ti.

Before coating the surface is cleaned preferably by applying a soft ion etching. The ion etching is performed in an Ar atmosphere or in a mixture of Ar and $H_2$.

The evaporation current is between 50 A and 200 A depending on cathode size and cathode material. When using cathodes of 63 mm in diameter the evaporation current is preferably between 60 A and 100 A. The substrate bias is between -20 V and -35 V. The deposition temperature is between 400°C and 700°C, preferably between 500°C and 600°C.

The (Ti,Al)N-layer is grown in an Ar+$N_2$ atmosphere consisting of 0-50 vol-% Ar, preferably 0-20 vol-%, at a total pressure of 1.0 Pa to 7.0 Pa, preferably 3.0 Pa to 5.5 Pa.

On top of the (Ti,Al)N-layer a TiN-layer of between 0.1 and 0.5 $\mu$m thickness may be deposited using arc evaporation as known.

The present invention also relates to the use of inserts according to the above for wet machining of superalloys such as Inconel 718, Inconel 625, Nimonic 81, Waspaloy or Ti6Al4V, at a cutting speed of 20-75 m/min, a cutting depth 0.2-2.5 mm and a feed of 0.05-0.30 mm/rev.

Example 1

Cemented carbide cutting tool inserts of type CNMG120412-MR3 and CNMG120408-MF1 consisting of a substrate and a coating were prepared. The substrate was made by milling, pressing and sintering. The composition was 5.9 wt-% Co, 0.27 wt-% Cr and rest WC. The coercivity was 24.0 kA/m corresponding to an average WC grain size of about 0.80 $\mu$m.

The inserts were wet-blasted to an edge-radius of 25 $\mu$m.

The coating was grown using arc evaporation of a $Ti_{0.34}Al_{0.66}$ cathode, 63 mm in diameter. The deposition was carried out in a 99.995% pure $N_2$ atmosphere at a total pressure of 4.5 Pa, using a substrate bias of -30 V for 60 minutes. The deposition temperature was about 530°C. The thickness of the layer was 3.8 $\mu$m in the middle of the flank face. X-ray diffraction showed a strong (002)-texture with (TC)=1.8 and a residual strain of $3.5*10^{-3}$.

Figure 1 shows a fracture surface of the insert.

Example 2

CNMG120412-MR3 coated inserts from Example 1 were tested with regard to wear resistance in longitudinal medium-rough turning at the following conditions.

| | |
|---|---|
| Work piece: | Cylindrical bar |
| Material: | Inconel 718 |
| Cutting speed: | 50 m/min |
| Feed: | 0.25 mm/rev |
| Depth of cut: | 2.0 mm |
| Remarks: | Flood coolant |
| Reference: | Seco CP200 |

Results

The tool life criterion was the maximum time in cut in minutes at a cutting speed of 50 m/min giving a flank wear of 0.2 mm. The results are found in Table 1.

Table 1.

| Grade | Time in cut [min] |
|---|---|
| Invention | 8.50 |
| Seco CP200 | 6.00 |

This test shows that the inserts according to the invention achieve about 40 % longer tool life than Seco CP200.

Example 3

CNMG120408-MF1 coated inserts from Example 1 were tested with regard to wear resistance in longitudinal fine turning at the conditions below.

| Work piece: | Cylindrical bar |
|---|---|
| Material: | Inconel 718 |
| Cutting speed: | 55, 70 m/min |
| Feed: | 0.15 mm/rev |
| Depth of cut: | 0.5 mm |
| Remarks: | Flood coolant |
| Reference: | Seco CP200 |

Results

The time in minutes to a flank wear of 0.2 mm was measured. The results are found in Table 2.

Table 2.

| Cutting speed | 55 | 70 |
|---|---|---|
| Invention | - | 7.00 |
| Seco CP200 | 7.00 | 5.00 |

This test shows that the inserts according to the invention increase tool life productivity by 40 % compared to Seco CP200.

Example 4

CNMG120412-MR3 coated inserts from Example 1 were tested with regard to tool life in a medium-rough boring operation at the conditions below.

| Work piece: | Special component |
|---|---|
| Material: | Inconel 718 |
| Cutting speed: | 37 m/min |
| Feed: | 0.20 mm/rev |
| Depth of cut: | 3.2 mm |
| Remarks: | Flood coolant |
| Reference: | Competitor grade |

Results

Reference grade machined reached full tool life after 7 minutes and 40 seconds. The inserts according to the invention reached full tool life after 11 minutes and 50 seconds.
This test shows that the inserts according to the invention increase tool life up to 50%.

Claims

1. A cutting tool insert, comprising a cemented carbide body and a coating particularly useful in general turning of superalloys, **characterized in**
a composition of the cemented carbide of WC, 5.0-7.0 wt-% Co, 0.22-0.43 wt%-Cr and a coercivity, Hc, of 19-28 kA/m, a coating of one layer of $(Ti_xAl_{1-x})N$, where x is between 0.25 and 0.50 with a crystal structure of NaCl type and a total thickness between 3.0 and 5.0 $\mu$m measured on the middle of the flank face,

with a compressive residual strain of between $2.5*10^{-3}$ and $5.0*10^{-3}$
and with a texture coefficient TC(200) between 1.6 and 2.1, the texture coefficient (TC) being defined as:

$$TC(hkl) = \frac{I(hkl)}{I_0(hkl)} \left[ \frac{1}{n} \sum_{n=1}^{n} \frac{I(hkl)}{I_0(hkl)} \right]^{-1}$$

where
I(hkl) = intensity of the (hkl) reflection
$I_0$(hkl) = standard intensity according to JCPDS card no 38-1420
n = number of reflections used in the calculation (hkl) reflections used are: (111), (200), (220).

2. A cutting tool insert according to claim 1) **characterized in** a Co-content of 5.5-6.5 wt-%.

3. A cutting tool insert according to claim 1) **characterized in** a Cr-content of 0.24-0.33 wt-%.

4. A cutting tool insert according to claim 1) **characterized in** a coercivity, Hc, of 21-27 kA/m.

5. A cutting tool insert according to claim 1) **characterized in** an x-value of between 0.30 and 0.40.

6. A cutting tool insert according to claim 1) **characterized in** a total coating thickness between 3.5 and 4.5 $\mu$m.

7. A cutting tool insert according to claim 1) **characterized in** a compressive residual strain between $3.0*10^{-3}$ and $4.0*10^{-3}$.

8. A cutting tool insert according to claim 1) **characterized in** an outermost TiN-layer of between 0.1 and 0.5 $\mu$m thickness.

9. A cutting tool insert according to any of the preceding claims **characterized in** an edge radius of between 15 and 30 $\mu$m.

10. A method for making a cutting tool insert, comprising a cemented carbide body and a coating particularly useful in general turning of superalloys, **characterized in** providing a substrate by conventional powder metallurgical methods milling, pressing and sintering with a composition of WC, 5.0-7.0 wt-% Co,0.22-0.43 wt%-Cr and a coercivity, Hc, of 19-28 and depositing a single layer of $(Ti_xAl_{1-x})N$, where x is between 0.25 and 0.50 with a crystal structure of NaCl type and a total thickness between 3.0 and 5.0 $\mu$m measured on the middle of the flank face
with a compressive residual strain of between $2.5*10^{-3}$ and $5.0*10^{-3}$,
and with a texture coefficient TC(200) between 1.6 and 2.1, the texture coefficient (TC) being defined as:

$$TC(hkl) = \frac{I(hkl)}{I_0(hkl)} \left[ \frac{1}{n} \sum_{n=1}^{n} \frac{I(hkl)}{I_0(hkl)} \right]^{-1}$$

where
I(hkl) = intensity of the (hkl) reflection $I_0$(hkl) = standard intensity according to JCPDS card no 38-1420
n = number of reflections used in the calculation (hkl) reflections used are: (111), (200), (220).
using arc evaporation of an alloyed, or Ti+Al composite cathode with the composition of 25 to 50 at-% Ti and a current between 50 A and 200 A depending on cathode size and cathode material, the substrate bias of between -20 V and -35 V, a deposition temperature of between 400°C and 700°C and grown in an Ar+$N_2$ atmosphere consisting of 0-50 vol-% Ar at a total pressure of 1.0 Pa to 7.0 Pa.

11. A cutting tool insert according to claim 10) **characterized in** a Co-content of 5.5-6.5 wt-%.

12. A cutting tool insert according to claim 10) **characterized in** a Cr-content of 0.24-0.33 wt-%.

13. A cutting tool insert according to claim 10) **characterized in** a coercivity, Hc, of 21-27 kA/m.

**14.** A cutting tool insert according to claim 10) **characterized in** an x-value of between 0.30 and 0.40.

**15.** A cutting tool insert according to claim 10) **characterized in** a total coating thickness between 3.5 and 4.5 $\mu$m.

**16.** A cutting tool insert according to claim 10) **characterized in** a compressive residual strain between $3.0*10^{-3}$ and $4.0*10^{-3}$.

**17.** A cutting tool insert according to claim 10) **characterized in** a composition of the cathode of 30 to 40 at-% Ti.

**18.** A cutting tool insert according to claim 10) **characterized in** an Ar+$N_2$ atmosphere consisting of 0-20 vol-% Ar.

**19.** A method according to claim 10)
**characterized in** depositing an outermost TiN-layer of between 0.1 and 0.5 $\mu$m thickness using arc evaporation.

**20.** A method according to claim 10 to 19
**characterized in that** the insert is edge-honed by wet-blasting to an edge radius of between 15 and 30 $\mu$m before coating.

**21.** Use of an insert according to claims 1)-9) for general machining of superalloys such as Inconel 718, Inconel 625, Nimonic 81, Waspaloy or Ti6Al4V, at a cutting speed of 20-75 m/min, a cutting depth 0.2-2.5 mm and a feed of 0.05-0.30 mm/rev.

**Patentansprüche**

**1.** Schneidwerkzeugeinsatz, der aus einem Hartmetallkörper und einer Beschichtung besteht und insbesondere bei der allgemeinen Drehbearbeitung von Superlegierungen von Nutzen ist, **gekennzeichnet durch**
eine Hartmetall-Zusammensetzung aus WC, 5,0-7,0 Gew.-% Co, 0,22-0,43 Gew.-% Cr und einer Koerzitivfeldstärke Hc von 19-28 kA/m,
eine Beschichtung aus einer Schicht von $(Ti_xAl_{1-x})N$, wobei x zwischen 0,25 und 0,50 beträgt, mit einer Kristallstruktur des NaCl-Typs und einer Gesamtdicke zwischen 3,0 und 5,0 $\mu$m, gemessen in der Mitte der Flankenfläche,
mit einer Druckeigenspannung zwischen $2,5*10^{-3}$ und $5,0*10^{-3}$
und mit einem Texturkoeffizienten TC(200) zwischen 1,6 und 2,1, wobei der Texturkoeffizient (TC) wie folgt definiert ist:

$$TC(hkl) = \frac{I(hkl)}{I_o(hkl)}\left[\frac{1}{n}\sum_{n=1}^{n}\frac{I(hkl)}{I_o(hkl)}\right]^{-1}$$

wobei
I(hkl) = Intensität der (hkl)-Reflexion
$I_o$(hkl) = Standardintensität gemäß JCPDS-Karte Nr. 38-1420
n = Anzahl der in der Berechnung verwendeten Reflexionen verwendete (hkl)-Reflexionen: (111), (200), (220).

**2.** Schneidwerkzeugeinsatz nach Anspruch 1, **gekennzeichnet durch** einen Co-Gehalt von 5,5-6,5 Gew.-%.

**3.** Schneidwerkzeugeinsatz nach Anspruch 1, **gekennzeichnet durch** einen Cr-Gehalt von 0,24-0,33 Gew.-%.

**4.** Schneidwerkzeugeinsatz nach Anspruch 1, **gekennzeichnet durch** eine Koerzitivfeldstärke Hc von 21-27 kA/m.

**5.** Schneidwerkzeugeinsatz nach Anspruch 1, **gekennzeichnet durch** einen x-Wert zwischen 0,30 und 0,40.

**6.** Schneidwerkzeugeinsatz nach Anspruch 1, **gekennzeichnet durch** eine Gesamtdicke der Beschichtung zwischen 3,5 und 4,5 $\mu$m.

**7.** Schneidwerkzeugeinsatz nach Anspruch 1, **gekennzeichnet durch** eine Druckeigenspannung zwischen $3.0*10^{-3}$ und $4,0*10^{-3}$.

8. Schneidwerkzeugeinsatz nach Anspruch 1, **gekennzeichnet durch** eine äußere TiN-Schicht mit einer Dicke zwischen 0,1 und 0,5 $\mu$m.

9. Schneidwerkzeugeinsatz nach einem der vorangegangenen Ansprüche, **gekennzeichnet durch** einen Kantenradius zwischen 15 und 30 $\mu$m.

10. Verfahren zum Herstellen eines Schneidwerkzeugeinsatzes, welcher aus einem Hartmetallkörper und einer Beschichtung besteht und insbesondere bei der allgemeinen Drehbearbeitung von Superlegierungen von Nutzen ist, **dadurch gekennzeichnet, dass** durch die herkömmlichen pulvermetallurgischen Verfahren Mahlen, Pressen und Sintern ein Substrat bereitgestellt wird, welches eine Zusammensetzung von WC, 5,0-7,0 Gew.-% Co, 0,22-0,43 Gew.-% Cr und eine Koerzitivfeldstärke Hc von 19-28 hat, und eine einzelne Schicht aus $(Ti_xAl_{1-x})N$ abgeschieden wird, wobei x zwischen 0,25 und 0,50 beträgt, mit einer Kristallstruktur des NaCl-Typs und einer Gesamtdicke zwischen 3,0 und 5,0 $\mu$m, gemessen in der Mitte der Flankenfläche,
mit einer Druckeigenspannung zwischen $2,5*10^{-3}$ und $5,0*10^{-3}$
und mit einem Texturkoeffizienten TC(200) zwischen 1,6 und 2,1, wobei der Texturkoeffi-zient wie folgt definiert ist:

$$TC(hkl) = \frac{I(hkl)}{I_o(hkl)} \left[ \frac{1}{n} \sum_{n=1}^{n} \frac{I(hkl)}{I_o(hkl)} \right]^{-1}$$

wobei
I(hkl) = Intensität der (hkl)-Reflexion
$I_o$(hkl) = Standardintensität gemäß JCPDS-Karte Nr. 38-1420
n = Anzahl der in der Berechnung verwendeten Reflexionen verwendete (hkl)-Reflexionen: (111), (200), (220),
unter Verwendung von Lichtbogenverdampfung einer legierten oder aus Ti+Al zusammengesetzten Kathode mit einer Zusammensetzung von 25 bis 50 At.-% Ti und einem Strom zwischen 50 A und 200 A, abhängig von der Kathodengröße und dem Kathodenmaterial, einer Substratvorspannung zwischen -20 V und -35 V, einer Abscheidungstemperatur zwischen 400°C und 700°C und gezüchtet in einer $Ar+N_2$-Atmosphäre, bestehend aus 0-50 Vol.-% Ar bei einem Gesamtdruck von 1,0 Pa bis 7,0 Pa.

11. Schneidwerkzeugeinsatz nach Anspruch 10, **gekennzeichnet durch** einen Co-Gehalt von 5,5-6,5 Gew.-%.

12. Schneidwerkzeugeinsatz nach Anspruch 10, **gekennzeichnet durch** einen Cr-Gehalt von 0,24-0,33 Gew.-%

13. Schneidwerkzeugeinsatz nach Anspruch 10, **gekennzeichnet durch** eine Koerzitivfeldstärke Hc von 21-27 kA/m.

14. Schneidwerkzeugeinsatz nach Anspruch 10, **gekennzeichnet durch** einen x-Wert zwischen 0,30 und 0,40.

15. Schneidwerkzeugeinsatz nach Anspruch 10, **gekennzeichnet durch** eine Gesamtdicke der Beschichtung zwischen 3,5 und 4,5 $\mu$m.

16. Schneidwerkzeugeinsatz nach Anspruch 10, **gekennzeichnet durch** eine Druckeigenspannung zwischen $3,0*10^{-3}$ und $4,0*10^{-3}$.

17. Schneidwerkzeugeinsatz nach Anspruch 10, **gekennzeichnet durch** eine Kathodenzusammensetzung von 30 bis 40 At.-% Ti.

18. Schneidwerkzeugeinsatz nach Anspruch 10, **gekennzeichnet durch** eine $Ar+N_2$-Atmosphäre, bestehend aus 0-20 Vol.-% Ar.

19. Verfahren nach Anspruch 10, **dadurch gekennzeichnet, dass** eine äußere TiN-Schicht mit einer Dicke zwischen 0,1 und 0,5 $\mu$m unter Verwendung von Lichtbogenverdampfung abgeschieden wird.

20. Verfahren nach einem der Ansprüche 10 bis 19, **dadurch gekennzeichnet, dass** vor dem Beschichten die Kante des Einsatzes mittels Nassstrahlen auf einen Kantenradius zwischen 15 und 30 $\mu$m abgeschliffen wird.

21. Verwendung eines Einsatzes nach einem der Ansprüche 1 bis 9 für das allgemeine Bearbeiten von Superlegierungen, wie Inconel 718, Inconel 625, Nimonic 81, Waspaloy oder Ti6Al4V, bei einer Schneidgeschwindigkeit von 20-75 m/Min., einer Schnitttiefe von 0,2-2,5 mm und einem Vorschub von 0,05-0,30 mm/U.

**Revendications**

1. Un insert de coupe comprenant un corps en carbure cémenté et un revêtement particulièrement utile pour le tournage général de superalliages, **caractérisé en ce qu'**il comprend :

   - une composition de carbure cémenté de WC, de 5,0 à 7,0 % en masse de Co, de 0,22 à 0,43 % en masse de Cr et une coercivité, Hc, de 19 à 28 kA/m,
   - un revêtement d'une couche de $(Ti_xAl_{1-x})N$, où x est compris entre 0,25 et 0,50 avec une structure cristalline du type NaCl et une épaisseur totale entre 3,0 et 5,0 $\mu$m mesurée sur le milieu de la face de flanc,
   avec une déformation permanente en compression entre $2,5*10^{-3}$ et $5,0*10^{-3}$
   et avec un coefficient de texture TC(200) entre 1,6 et 2,1, le coefficient de texture étant défini comme :

   $$TC(hkl) = \frac{I(khl)}{I_0(hkl)} \left[ \frac{1}{n} \sum_{n=1}^{n} \frac{I(khl)}{I_0(hkl)} \right]^{-1}$$

   où
   I(hkl) = intensité de la réflexion (hkl)
   $I_0$(hkl) = intensité standard selon la carte JCPDS numéro 38-1420
   n = nombre de réflexions utilisées dans le calcul
   les réflexions (hkl) utilisées étant ; (111), (200), (220).

2. Un insert de coupe selon la revendication 1, **caractérisé par** une teneur en Co de 5,5 à 6,5 % en masse.

3. Un insert de coupe selon la revendication 1, **caractérisé par** une teneur en Cr de 0,24 à 0,33 % en masse.

4. Un insert de coupe selon la revendication 1, **caractérisé par** une coercivité, Hc, de 21 à 27 kA/m.

5. Un insert de coupe selon la revendication 1, **caractérisé par** une valeur de x entre 0,30 et 0,40.

6. Un insert de coupe selon la revendication 1, **caractérisé par** une épaisseur totale du revêtement entre 3,5 et 4,5 $\mu$m.

7. Un insert de coupe selon la revendication 1, **caractérisé par** une déformation résiduelle en compression entre $3,0*10^{-3}$ et $4,0*10^{-3}$.

8. Un insert de coupe selon la revendication 1, **caractérisé par** une couche extérieure de TiN d'épaisseur entre 0,1 et 0,5 $\mu$m.

9. Un insert de coupe selon l'une quelconque des revendications précédentes, **caractérisé par** un rayon d'arête entre 15$\mu$m et 30$\mu$m,

10. Un procédé pour la fabrication d'un insert de coupe comprenant un corps en carbure cémenté et un revêtement particulièrement utile pour le tournage général de superalliages, **caractérisé en ce que** le procédé comprend la fourniture d'un substrat par les procédés de broyage conventionnel des poudres métallurgiques, le pressage et le frittage avec une composition de WC, de 5,0 à 7,0 % en masse de Co, de 0,22 à 0,43 en masse de Cr et une coercivité, Hc, de 19 à 28 et le dépôt d'une seule couche de $(Ti_xAl_{1-x})N$, où x est compris entre 0,25 et 0,50 avec une structure cristalline du type NaCl et une épaisseur totale entre 3,0 et 5,0 $\mu$m mesurée sur le milieu de la face de flanc,
    avec une déformation résiduelle en compression entre $2,5*10^{-3}$ et $5,0*10^{-3}$,
    et avec un coefficient de texture TC(200) entre 1,6 et 2,1, le coefficient de texture étant défini comme :

    $$TC(hkl) = \frac{I(khl)}{I_0(hkl)} \left[ \frac{1}{n} \sum_{n=1}^{n} \frac{I(khl)}{I_0(hkl)} \right]^{-1}$$

où

I(hkl) = intensité de la réflexion (hkl)

$I_0$(hkl) = intensité standard selon la carte JCPDS numéro 38-1420

n = nombre de réflexions utilisées dans le calcul

les réflexions (hkl) utilisées étant : (111), (200), (220) ;

l'utilisation de l'évaporation à arc d'une cathode en alliage ou en un composite de Ti + Al, avec une composition de 25 à 50 % en atome de Ti et un courant entre 50 A et 200 A selon la taille de la cathode et le matériau de la cathode, une polarisation du substrat entre -20 V et -35 V, une température de déposition entre 400°C et 700°C et une croissance dans une atmosphère de Ar+$N_2$ consistant en 0 à 50 % en volume de Ar à une pression totale de 1,0 Pa à 7,0 Pa.

11. Un insert de coupe selon la revendication 10, **caractérisé par** une teneur en Co de 5,5 à 6,5 % en masse.

12. Un insert de coupe selon la revendication 10, **caractérisé par** une teneur en Cr de 0,24 à 0,33 % en masse.

13. Un insert de coupe selon la revendication 10, **caractérisé par** une coercivité, Hc, de 21 à 27 kA/m.

14. Un insert de coupe selon la revendication 10, **caractérisé par** une valeur de x entre 0,30 et 0,40.

15. Un insert de coupe selon la revendication 10, **caractérisé par** une épaisseur totale du revêtement entre 3,5 et 4,5 $\mu$m.

16. Un insert de coupe selon la revendication 10, **caractérisé par** une entre

17. Un insert de coupe selon la revendication 10, **caractérisé par** une composition de la cathode de 30 à 40 % en atome de Ti.

18. Un insert de coupe selon la revendication 10, **caractérisé par** une atmosphère de Ar+$N_2$ consistant de 0 à 20 % en volume de Ar.

19. Un procédé selon la revendication 10, **caractérisé par** une déposition d'une couche externe de TiN d'épaisseur entre 0,1 et 0,5 $\mu$m par l'utilisation de l'évaporation à arc.

20. Un procédé selon l'une des revendications 10 à 19, **caractérisé en ce qu'**avant le revêtement, l'insert est rodé sur les arêtes par sablage humide jusqu'à un rayon d'arête entre 15$\mu$m et 30$\mu$m.

21. Utilisation d'un insert selon l'une des revendications 1 à 9 pour l'usinage général de superalliages tel que Inconel 718, Inconel 625, Nimonic 81, Waspaloy ou Ti6Al4V, à une vitesse de coupe de 20 à 75 m/min, une profondeur de coupe de 0,2 à 2,5 mm et une avance de 0,05 à 0,30 mm/tour.

**Fig 1.**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 1798308 A2